# EUROPÄISCHE PATENTSCHRIFT

(11) **EP 3 180 969 B1**
(45) Veröffentlichungstag und Bekanntmachung des Hinweises auf die Patenterteilung: **08.07.2020**
(21) Anmeldenummer: 15778631.0
(22) Anmeldetag: 02.10.2015
(51) Int. Cl.: H05K 13/08

(54) **BESTÜCKEN VON LEITERPLATTEN**
POPULATION OF PRINTED CIRCUIT BOARDS
ÉQUIPEMENT DE CARTES À CIRCUIT IMPRIMÉ

(30) Priorität: 11.11.2014 DE 102014222936
(43) Veröffentlichungstag der Anmeldung: 21.06.2017
(73) Patentinhaber: Siemens Aktiengesellschaft, 80333 München (DE)
(72) Erfinder: PFAFFINGER, Alexander, 81739 München (DE); ROYER, Christian, 85521 Ottobrunn (DE)
(86) Internationale Anmeldenummer: PCT/EP2015/072828
(87) Internationale Veröffentlichungsnummer: WO 2016/074851

(56) Entgegenhaltungen:
- WO-A1-2014/079601
- DE-A1-102012 211 810
- DE-T2- 69 120 887
- DE-T2- 69 120 887

## Beschreibung

Die vorliegende Erfindung betrifft ein Verfahren und ein System zur Bestückung von Leiterplatten. Dabei wird eine Bestückungslinie vorausgesetzt, die dazu eingerichtet ist, Leiterplatten mit Bauelementen zu bestücken.

Eine elektronische Baugruppe umfasst eine Leiterplatte und Bauelemente, die auf ihr mechanisch und elektrisch befestigt sind. Zur Herstellung der Leiterplatte werden die Bauelemente mittels eines Bestückungsautomaten (pick-and-place) auf der Leiterplatte abgelegt und anschließend in einem Reflow-Ofen mit ihr verlötet. Mehrere Bestückungsautomaten können auf einer Bestückungslinie nacheinander durchlaufen werden. Zur Herstellung vieler Leiterplatten kann ein Bestückungssystem verwendet werden, das mehrere Bestückungslinien umfasst.

Eine Zusammensetzung von Bauelementetypen am Bestückungsautomat wird Rüstung genannt. Mit einer Rüstung kann eine Menge von unterschiedlichen Leiterplatten gefertigt werden, die Rüstfamilie genannt wird. Üblicherweise sollen jedoch Leiterplatten von mehr unterschiedlichen Leiterplattentypen gefertigt werden, als mittels einer Rüstung möglich ist, sodass die Rüstung während der Produktion geändert werden muss.

Eine Rüstung kann auf einem oder mehreren Rüsttischen gehalten werden, die leicht am Bestückungsautomaten ausgewechselt werden können. Ein Aufrüsten eines Rüsttischs mit Bauelementen von vorbestimmten Bauelementetypen ist jedoch häufig aufwändig. Die Rüstungen werden daher oft in Festrüstungen und Variantenrüstungen unterschieden, wobei ein Festrüstungstisch dazu vorgesehen ist, seine Zusammensetzung von Bauelementetypen über einen vorbestimmten Planungshorizont zu behalten, während ein Variantenrüsttisch voraussichtlich innerhalb des Planungshorizonts umgerüstet wird.

DE 10 2012 220 904 A1 betrifft ein Verfahren zur Bestimmung einer Festrüstung für eine Bestückungslinie.

DE 691 20 887 T2 schlägt vor, eine erste und mehrere zweite Rüstfamilien derart zu bilden, dass eine Rüstung für die erste und eine Rüstung für eine der zweiten Rüstfamilien gleichzeitig an einer Bestückungslinie gerüstet sein können. Während jeder Veränderung an der zweiten Rüstung können Leiterplatten aus der ersten Rüstfamilie gefertigt werden.

WO 2014/079601 A1 betrifft ein Verfahren zur Optimierung einer Zuordnung von Leiterplattentypen zu Rüstfamilien, wobei die Optimierung nacheinander bezüglich zweier verschiedener Qualitätskriterien erfolgt.

DE 10 2012 211810 A1 beschreibt ein Verfahren zur Minimierung von Rüstfamilien für eine Bestückungslinie.

Häufig kommt es jedoch trotz hoch optimierter Rüstungen bzw. Rüstfamilien beim Betrieb einer Bestückungslinie zu einem vorübergehenden Produktionsstillstand, weil die Produktion mittels einer an der Bestückungslinie angebrachten ersten Rüstung bereits abgeschlossen ist, bevor alle Rüsttische einer zweiten Rüstung fertig mit Bauelementen ausgestattet werden konnten. Der Erfindung liegt daher die Aufgabe zu Grunde, eine verbesserte Technik zur Bestückung von Leiterplatten anzugeben. Die Erfindung löst die Aufgabe mittels der Gegenstände der unabhängigen Ansprüche. Unteransprüche geben bevorzugte Ausführungsformen wieder.

Zum Bestücken von Leiterplatten mittels einer Bestückungslinie werden mehrere Rüstungen mit jeweils zugeordneten Rüstfamilien gebildet. Jeder Rüstung ist eine Anzahl Bauelementetypen und jeder zugeordneten Rüstfamilie eine Anzahl Leiterplattentypen zugeordnet, sodass eine Leiterplatte eines Leiterplattentyps einer Rüstfamilie mittels Bauelementen der Bauelementetypen der Rüstung an der Bestücklinie bestückt werden kann. Ein Rüsttisch mit einem Vorrat von Bauelementen eines Bauelementetyps einer Rüstung kann an der Bestückungslinie bereitgestellt werden. Ein Verfahren zum Bestücken der Leiterplatten umfasst Schritte des Erfassens von Leiterplattentypen, von denen Leiterplatten mit Bauelementen zugeordneter Bauelementetypen bestückt werden sollen, und des Zuordnens von erfassten Leiterplattentypen zu Rüstfamilien. Anschließend wird eine Abfolge bestimmt, in der die Rüstungen der gebildeten Rüstfamilien an der Bestückungslinie gerüstet werden sollen, und die Abfolge wird bezüglich eines vorbestimmten Kriteriums optimiert. Danach können Leiterplatten mittels Rüstungen in der vorbestimmten Abfolge bestückt werden.

Durch das Bilden der Abfolge können Rüstwechsel berücksichtigt werden, die einen physikalischen Eingriff in die Ausstattung der Bestückungslinie darstellen. Beispielsweise kann darauf geachtet werden, dass nicht zu viele, nicht zu rasch aufeinander folgende oder nicht zu umfangreiche Rüstwechsel stattfinden. Das Anhalten und Wiederanlaufen der Bestückungslinie kann dadurch reduziert sein. Außerdem können die Rüstungen realistischerweise unter Beachtung ihrer Übergänge in Form von Rüstwechseln beurteilt werden. Die Abfolge der Rüstungen ist somit nicht mehr zufällig, sondern wird dem zu optimierenden Kriterium unterworfen.

Das Kriterium kann unterschiedliche Formen annehmen. Beispielsweise kann das Kriterium eines von einer Anzahl von Rüstungen, einer Anzahl Rüstwechsel, einer Anzahl von an Rüsttischen anzubringenden Vorräten von Bauelementen und einem Produktionsvolumen in einer Festrüstung umfassen. Es können auch mehrere der genannten Größen zu einem Kriterium miteinander vereinigt werden, beispielsweise in Form einer ungewichteten oder gewichteten Summe.

Üblicherweise umfasst die Abfolge wenigstens zwei Rüstungen, wobei auf eine erste Rüstung eine zweite Rüstung folgt. Das Kriterium umfasst in einer bevorzugten Ausführungsform, dass eine Wartezeit zwischen dem Ende der Bestückung von Leiterplatten mittels der ersten Rüstung und dem fertigen Bereitstellen eines Rüsttischs mit einem Vorrat von Bauelementen eines Bauelementetyps der zweiten Rüstung möglichst klein ist. Idealerweise ist die Wartezeit möglichst oft null. Negative Werte, wenn alle Rüsttische der zweiten Rüstung bereitgestellt werden können, bevor das Bestücken mittels der ersten Rüstung abgeschlossen ist, werden hier nicht betrachtet.

Eine Wartezeit kann besonders kritisch auf die Auslastung bzw. Effizienz der Bestückungslinie wirken. Durch das Minimieren der Wartezeit kann die Bestückungslinie daher verbessert kosten- oder ressourcensparend betrieben werden.

Es ist besonders bevorzugt, dass eine Gesamtwartezeit, die sich aus den Wartezeiten bei allen Rüstwechseln der Abfolge zusammensetzt, minimiert wird. Dadurch können einzelne Wartezeiten verbessert toleriert werden, um ein verbessertes Gesamtergebnis mit einer verringerten Gesamtwartezeit zu erzielen.

Eine der bestimmten Rüstungen kann eine Festrüstung sein, deren Bauelementetypen unverändert an einem oder mehreren Rüsttischen gerüstet bleiben, solange Leiterplatten mittels Rüstungen der bestimmten Abfolge bestückt werden.

Durch den Einsatz einer Festrüstung können Wartezeiten eliminiert werden, indem die Reihenfolge derart gebildet wird, dass die Festrüstung an der Bestückungslinie angebracht wird, wenn keine andere Rüstung bereitsteht. Die mittels der Festrüstung zu bestückenden Leiterplattentypen müssen auch nicht in voller Stückzahl zusammenhängend bestückt werden, vielmehr kann die Festrüstung gegen eine Variantenrüstung ausgetauscht werden, sobald diese zur Rüstung bereitsteht. So kann eine vergrößerte Anzahl von Rüstwechseln zu einer Variantenrüstung mittels der Festrüstung wartezeitfrei gestaltet werden. In einer Ausführungsform des Verfahrens liegt in der Abfolge zwischen zwei Variantenrüstungen stets eine Festrüstung.

Das Zuordnen von Leiterplattentypen zu Rüstfamilien kann mit wenigstens einem geänderten Parameter wiederholt werden, um das Kriterium zu optimieren. Anders ausgedrückt können das Zuordnen, das Bestimmen der Abfolge und das Optimieren der Abfolge unter Variation eines oder mehrerer Parameter durchgeführt werden. So kann bestimmt werden, welcher Parameter bzw. welche Parameterkombination einen signifikanten Einfluss auf die Verbesserung des Kriteriums hat. So kann eine verbesserte Abfolge von Rüstfamilien bzw. Rüstungen der Bestückung von Leiterplatten zu Grunde gelegt werden.

In einer besonders bevorzugten Ausführungsform umfasst der Parameter eine Auswahl von zugeordneten Leiterplattentypen aus der Menge der erfassten Leiterplattentypen. Es wird davon ausgegangen, dass die Menge der erfassten Leiterplattentypen größer als die Menge der zugeordneten Leiterplattentypen ist. Die Auswahl der Untermenge aus der Obermenge kann dabei signifikanten Einfluss auf das Kriterium haben. Beispielswiese kann ein Leiterplattentyp, der mit anderen Leiterplattentypen schlecht kombinierbar ist, aus der Menge der zugeordneten Leiterplattentypen entfernt werden, sodass die anderen Leiterplattentypen in eine verbesserte Abfolge gebracht werden können. Der zunächst zurückgewiesene Leiterplattentyp kann zu einem späteren Zeitpunkt mit anderen Leiterplattentypen kombiniert werden, die sich zu diesem Zeitpunkt in der Menge der erfassten Leiterplattentypen befinden.

Der Parameter kann auch die Menge der erfassten Leiterplattentypen umfassen. Beispielsweise kann zwischen zwei Durchläufen des Verfahrens die Menge der erfassten Leiterplattentypen um einen neuen Auftrag erweitert worden sein. Die Menge kann auch verkleinert worden sein, wenn beispielsweise ein anderes Verfahren Leiterplattentypen einer anderen Bestückungslinie zugeordnet hat. So kann ein Bestückungssystem mit mehreren Bestückungslinien mit individuellen Zuordnungsverfahren arbeiten.

Der Parameter kann zusätzlich oder alternativ eine Festrüstung, die Rüsttische umfasst, deren zugeordnete Bauelementetypen nicht verändert werden, eine Priorität, die einem Auftrag zur Bestückung von Leiterplatten zugeordnet ist, einen Füllgrad einer Rüstung, eine Anzahl von Leiterplattentypen in einer Rüstfamilie oder eine andere Größe umfassen.

In einer weiteren Ausführungsform kann auch eine Kombination mehrerer Kriterien verwendet werden. Die Kriterien können in einer Ausführungsform auch gewichtet sein.

Ein Computerprogrammprodukt umfasst Programmcodemittel zur Durchführung des oben beschriebenen Verfahrens, wenn das Computerprogrammprodukt auf einer Verarbeitungseinrichtung abläuft oder auf einem computerlesbaren Medium gespeichert ist.

Ein System zur Bestückung von Leiterplatten umfasst eine Bestückungslinie und eine Verarbeitungseinrichtung zur Durchführung des oben beschriebenen Verfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
- Fig. 1: ein Bestückungssystem;
- Fig. 2: ein Ablaufdiagramm eines Verfahrens zur Bestimmung einer Abfolge von Rüstungen an einer Bestückungslinie des Bestückungssystems von Fig. 1; und
- Fig. 3: eine Abfolge von Rüstungen an einer Bestückungslinie des Bestückungssystems von Fig. 1
darstellt.

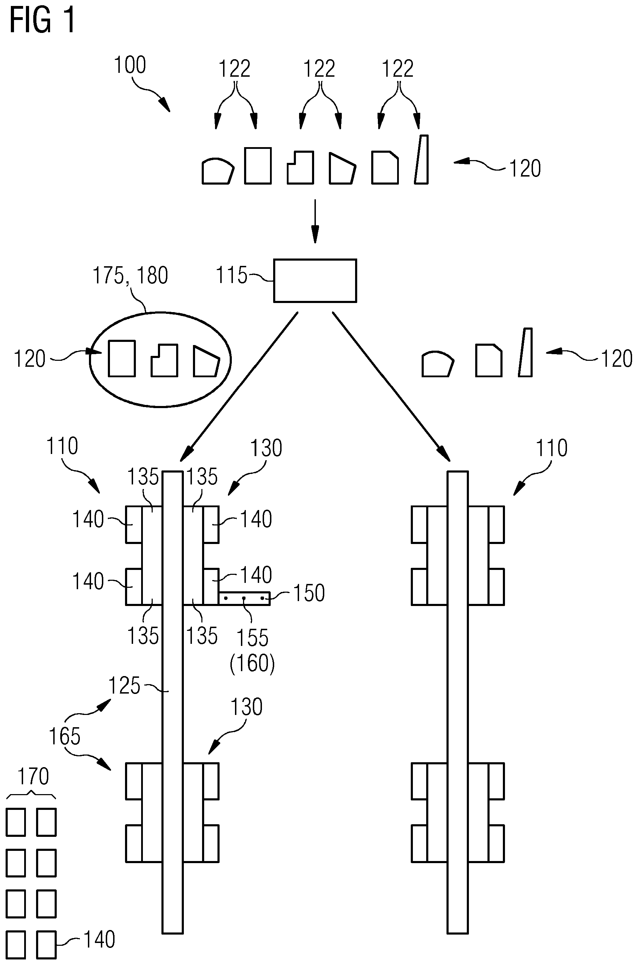

Figur 1 zeigt ein beispielhaftes Bestückungssystem 100. Das Bestückungssystem 100 umfasst eine oder mehrere Bestückungslinien 110 und eine Verarbeitungs- oder Steuereinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 ein Bauelement 155 aufzunehmen und an einer vorbestimmten Position auf der Leiterplatte 120 zu positionieren, die sich auf dem Transportsystem 125 befindet. Während des Bestückungsvorgangs steht die Leiterplatte 120 bezüglich des Bestückungsautomaten 130 üblicherweise still.

Die Rüsttische 140 umfassen üblicherweise mehrere Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementetyps 160 bereit. Für die Bauelemente 155 hat die Zuführungseinrichtung 150 üblicherweise ein Fassungsvermögen, das in Spuren ausgedrückt werden kann. Eine Spur ist für gewöhnlich 8 mm breit und die Zahl der Spuren eines Rüsttischs 140 ist beschränkt, beispielsweise auf 40. Bauelemente 155 des gleichen Bauelementetyps 160 sind üblicherweise bereitgestellt in einem Gurt, auf einem Tablett oder in einer Röhre.

Jeder Bauelementetyp 160 erfordert an der Zuführungseinrichtung 150 und am Rüsttisch 140 eine vorbestimmte Anzahl Spuren, die üblicherweise aneinander angrenzen. Die Anzahl der Bauelemente 155 eines Bauelementetyps 160 in einer Zuführungseinrichtung 150 wird hier vereinfachend als praktisch unendlich groß angesehen, sodass ein Nachrüsten nicht erforderlich ist. Gewöhnlich kann eine Zuführungseinrichtung 150 zur Bereithaltung von Bauelementen 155 unterschiedlicher Bauelementetypen 160 konfiguriert werden und üblicherweise können unterschiedliche Zuführungseinrichtungen 150 an einem Rüsttisch 140 angebracht werden.

Wird am Bestückungsautomaten 130 ein Bauelement 155 eines Bauelementetyps 160 benötigt, der nicht an einem der Rüsttische 140 vorhanden ist, so wird üblicherweise nicht die Zuordnung von Bauelementen 155 an einem der angebrachten Rüsttische 140 verändert, sondern der Rüsttisch 140 wird komplett gegen einen anderen, passend bestückten Rüsttisch 140 ausgetauscht.

Eine Rüstung 165, 170 umfasst eine Menge von Bauelementetypen 160 und wird realisiert mittels einem oder mehreren Rüsttischen 140, die jeweils mit Vorräten von Bauelementen 155 der Bauelementetypen 160 der Rüstung 165, 170 ausgestattet sind, um an der Bestückungslinie 110 angebracht zu werden. Dabei kann zwischen Festrüstungen 165 und Variantenrüstungen 170 unterschieden werden. Eine Festrüstung 165 ist dazu vorgesehen, auf dem oder den Rüsttischen 140 über einen vorbestimmten Planungshorizont unverändert gerüstet zu bleiben, während eine Variantenrüstung 170 dazu eingerichtet ist, auf einem oder mehreren Rüsttischen 140 innerhalb des Planungshorizonts nur vorübergehend gerüstet zu bleiben. Der Planungshorizont kann beispielsweise einen bis ca. 10 Tage betragen. Eine Zeit- über die eine Variantenrüstung 165 auf einem oder mehreren Rüsttischen 140 realisiert ist, ist üblicherweise wesentlich kürzer als der Planungshorizont. Diese Zeit kann beispielsweise mehrere Stunden oder Tage betragen, üblicherweise jedoch nicht länger als eine Woche.

Eine Rüstfamilie 175, 180 umfasst eine Anzahl Leiterplattentypen 122 und ist genau einer Rüstung 156, 170 zugeordnet und umgekehrt. Dabei kann zwischen einer Festrüstungs-Rüstfamilie 175 und einer Variantenrüstungs-Rüstfamilie 180 unterschieden werden. Eine Festrüstungs-Rüstfamilie 175 ist einer Festrüstung 165 zugeordnet und umfasst Leiterplattentypen 122, deren zugeordneten Leiterplatten 120 mit Bauelementen 155 von Bauelementetypen 160 der zugeordneten Festrüstung 165 vollständig bestückt werden können. Entsprechend ist eine Variantenrüstungs-Rüstfamilie 180 einer Variantenrüstung 170 zugeordnet und umfasst Leiterplattentypen 122, deren zugeordneten Leiterplatten 120 mit Bauelementen 155 von Bauelementetypen 160 der zugeordneten Variantenrüstung 170 vollständig bestückt werden können.

Im Betrieb der Bestückungslinie 110 werden nacheinander verschiedene Rüstungen 165, 170 an der Bestückungslinie 110 angebracht, um jeweils zugeordnete Leiterplatten 120 zu bestücken. Ein Wechsel von Rüstungen 165, 170 an der Bestückungslinie 110 wird Rüstwechsel genannt und bedingt üblicherweise einen Stillstand der Bestückungslinie 110.

Um eine Festrüstung 165 oder eine Variantenrüstung 170 zu realisieren werden üblicherweise einer oder mehrere Rüsttische 140, während sie nicht an der Bestückungslinie 110 angebracht sind, mit Vorräten von Bauelementen 155 vorbestimmter Bauelementetypen 160 aufgerüstet. Bereits aufgerüstete Bauelemente 155 nicht benötigter Bauelementetypen 160 können zuvor abgerüstet werden oder gerüstet bleiben. Dieser Vorgang wird Vorrüstung genannt und kann eine Bearbeitungszeit im Bereich von einer oder mehreren Stunden, beispielsweise ca. 6-10 Stunden, erfordern.

Um den mit einer Variantenrüstung 170 verbundenen Aufwand des Aufrüstens und Abrüstens sowie des Rüstwechsels zu minimieren wird üblicherweise versucht, möglichst viele Leiterplattentypen 122 in Festrüstungen 165 aufzunehmen. Ein angestrebter Fall ohne Variantenrüstungen 170 ist in der Praxis jedoch kaum erzielbar.

Für den Betrieb der Bestückungslinie 110 ist es entscheidend, wie die Rüstfamilien 175, 180 bzw. die Rüstungen 165, 170 zusammengesetzt sind. Bei deren Bildung können Nebenbedingungen zu beachten sein, beispielsweise die Einhaltung einer begrenzten Fassungskapazität eines Rüsttisches 140 für Bauelementetypen 160 oder eine Gruppierung vorbestimmter Leiterplattentypen 160 in der gleichen Rüstfamilie 175, etwa aus Gründen der Verwendung bleihaltigen oder bleifreien Lötzinns.

Die Bildung von Rüstfamilien 175, 180 bzw. Rüstungen 165, 170 bzw. Rüstungen kann mittels der Steuereinrichtung 115 erfolgen. Außerdem kann die Steuereinrichtung 115 eine Abfolge bestimmen, in der die Rüstungen 165, 170 an der Bestückungslinie 110 gerüstet werden sollen. Ferner kann die Steuereinrichtung 115 die Bestückung auf einer Bestückungslinie 110 oder dem ganzen Bestückungssystem 100 steuern.

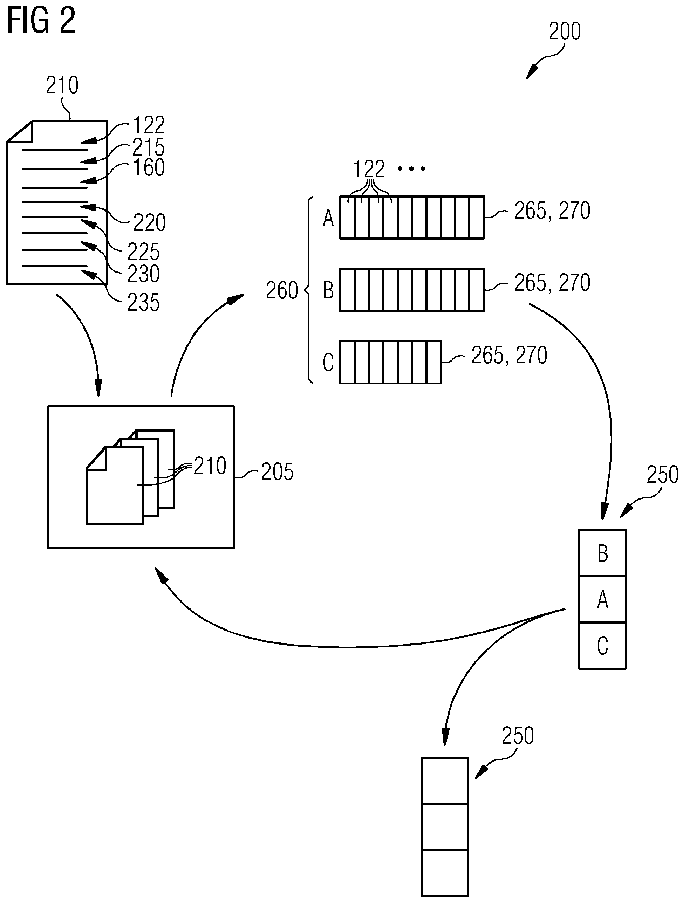

Figur 2 zeigt ein Ablaufdiagramm 200 eines Verfahrens zur Bestimmung einer Abfolge von Rüstungen an einer Bestückungslinie 110 des Bestückungssystems 100 von Fig. 1;

Es wird von einer Menge 205 von Aufträgen 210 ausgegangen, die möglichst effizient mittels einer Bestückungslinie 110 auszuführen sind. Jeder Auftrag 210 umfasst üblicherweise wenigstens einen Leiterplattentyp 122 und eine Stückzahl 215 zu bestückender Leiterplatten 120. Dem Leiterplattentyp 122 sind einer oder mehrere Bauelementetypen 160 zugeordnet, von denen Bauelemente 155 auf den einzelnen Leiterplatten 120 zu bestücken sind.

Einem Leiterplattentyp 122 können noch weitere Informationen zugeordnet sein. Beispielsweise können eine Anzahl 220 von Bauelementetypen 160, die auf jeder Leiterplatte 120 bestückt werden sollen, eine Anzahl 225 von Bestückpositionen einer Leiterplatte 120 oder eine Produktionszeit 230 für eine Leiterplatte 120 angegeben sein. Die Anzahl 225 der Bestückpositionen entspricht üblicherweise der Anzahl der auf einer Leiterplatte 120 des Leiterplattentyps 122 zu bestückenden Bauelemente 155, gleich welchen Bauelementetyps 160.

Einem Auftrag 210 kann eine Priorität 235 zugeordnet sein, die angibt, mit welcher Dringlichkeit der Auftrag 210 auszuführen ist.

Das Verfahren 200 entnimmt der Menge 205 Aufträge 210 und bildet daraus eine Abfolge 250 von Rüstungen 165, 170. Dabei kann das Verfahren 200 mehrfach nacheinander auf die Menge 205 zugreifen. Zwischen zwei Zugriffen kann sich die Menge 205 verändert haben, beispielsweise durch die Entnahme von Aufträgen 210 durch ein anderes Verfahren oder durch das Hinzufügen eines neu eingetroffenen Auftrags 210.

Das Verfahren kann als Simulation eingesetzt werden, sodass damit schnell und automatisiert der Einfluss unterschiedlicher Parameter studiert werden kann. Zu diesen Parametern können strategische Parameter zählen, die zwischen mehreren Bestückungslinien 110 stark unterschiedlich sein können. Zu den Parametern können beispielsweise einer oder mehrere der folgenden zählen:
- die Länge eines Planungshorizonts;
- eine vorbestimmte Festrüstung 165 und eine zugeordnete Festrüstungs-Rüstfamilie 175;
- Informationen über die Bestückungslinie 110 oder die zu verarbeitenden Leiterplattentypen 122, etwa
   o einen minimalen Spurbedarf eines Bauelements 155 auf einem Wechseltisch 140;
   o eine Anzahl von verfügbaren Wechseltischen 140;
   o Kapazitäten der einzelnen Wechseltische 140;
   o Zulässige Bauelementetypen 160 für die einzelnen Wechseltische 140;
- ein maximales Auftragsvolumen, das in einen nachfolgenden Planungshorizont verschoben werden darf;
- einen Füllgrad für einen Wechseltisch 140 durch Vorräte von Bauelementen 155 eines Bauelementtyps 160 einer Variantenrüstung 170; oder
- statistische Parameter.

Üblicherweise beschränkt sich die Aufgabe des Verfahrens 200 darauf, die Bestückungslinie 110 über einen vorbestimmten Planungshorizont 255 hinweg zu betreiben. Dazu werden Rüstungen bestimmt, die die Bestückungslinie 110 innerhalb des Planungshorizonts 205 möglichst gut auslasten und dabei eine effiziente Produktion ermöglichen. Der Planungshorizont 255 kann eine vorbestimmte Zeit umfassen, die beispielsweise einen oder mehrere Tage, oder ca. eine Woche betragen kann. Die Dauer des Planungshorizonts 255 wird üblicherweise anhand von technischen Kriterien der Bestückungslinie 110 sowie gegebenenfalls Informationen über ein übliches Auftragsaufkommen an der Bestückungslinie 110 festgelegt.

Ausgehend von der Menge 205 kann im Rahmen des Verfahrens 200 eine Teilmenge 260 von Aufträgen 210 bzw. Leiterplattentypen 122 gebildet werden, um die Grundmenge zur Bildung einer Zuordnung von Leiterplattentypen 122 zur Bestückungslinie 110 auf ein sinnvolles Maß zu verkleinern. Wie unten noch genauer gezeigt wird, kann die Teilmenge 260 auch sukzessive gebildet werden, indem sie bei mehreren Durchläufen des Verfahrens 200 gegebenenfalls abgeändert wird.

Leiterplattentypen 122 der Teilmenge 260 werden zu einer oder mehreren Rüstfamilien gruppiert. Dabei kann unterschieden werden zwischen einer Festrüstungs-Rüstfamilie 175 und einer Variantenrüstungs-Rüstfamilie 180. Eine Festrüstungs-Rüstfamilie 175 ist einer Festrüstung 165 zugeordnet, die dazu eingerichtet ist, innerhalb des Planungshorizonts 255 unverändert an einem oder mehreren Rüsttischen 140 realisiert zu bleiben. Eine Variantenrüstungs-Rüstfamilie 180 hingegen ist einer Variantenrüstung 170 zugeordnet, die dazu eingerichtet ist, innerhalb des Planungshorizonts 255 nur vorübergehend auf einem Rüsttisch 140 realisiert und dann ganz oder teilweise wieder davon entfernt zu werden. Ein Rüsttisch 140, der zur Realisierung einer Variantenrüstung 170 verwendet wird, wird innerhalb des Planungshorizonts 255 wenigstens einmal umgerüstet, wobei jedes Mal die Zusammensetzung von Vorräten von Bauelementen 155 von Bauelementetypen 160 am Rüsttisch 140 geändert wird.

In exemplarischer Weise werden in der Darstellung von Figur 2 drei Rüstfamilien 175, 180 gebildet, die mit A, B und C bezeichnet sind. Jeder Rüstfamilie 175, 180 ist eine Anzahl Leiterplattentypen 122 zugeordnet.

Für die Zuordnung von Leiterplattentypen 122 zu Rüstfamilien 175, 180 stehen unterschiedliche Verfahren zur Verfügung. Bevorzugterweise wird eine Zuordnung bestimmt und mittels Methoden der Linearen Optimierung verbessert. Die Lineare Optimierung ist die Grundlage der Lösungsverfahren der (Gemischt) Ganzzahligen Linearen Optimierung.

Vorteile der Linearen Optimierung:
- Globaler Optimierungsansatz
- Leicht erweiterbar
- Sehr gute kommerzielle Standard-Solver (Ilog, Gurobi, Xpress), die in der Praxis weit verbreitet und bewährt sind
- Für eine ermittelte Lösung ist bekannt, wie weit sie maximal von der optimalen Lösung entfernt ist (Gap).

Durch den Einsatz von mathematischen Verfahren lassen sich für die Zuordnung von Leiterplattentypen 122 zu Rüstfamilien 175 deutlich bessere Lösungen erzielen als mit bisher in der Praxis verwendeten Vorgehensweisen.

Zur Optimierung können unterschiedliche Verfahren verwendet werden, beispielsweise auf der Basis von lokalen Suchverfahren oder metaheuristischen Algorithmen. Bevorzugterweise wird jedoch ein IP-Modell (Integer Programmierung bzw. Integer Programm oder Gemischt Ganzzahliges Optimierungsmodell) verwendet. Eines der Hauptverfahren auf dem Gebiet der mathematischen Optimierung ist die Lineare Optimierung, die sich mit der Optimierung linearer Zielfunktionen über einer Menge befasst, die durch lineare Gleichungen und Ungleichungen eingeschränkt ist.

Die Zuordnung kann in einer Ausführungsform darauf ausgerichtet sein, Rüstfamilien 175, 180 mit einer vorbestimmten Qualität bezüglich eines vorbestimmten Kriteriums zu bestimmen. Beispielsweise kann das Kriterium die Auslastung eines an Rüsttischen 140 verfügbaren Platzes durch Bauelemente 155 einer der Rüstfamilie zugeordneten Rüstung 165, 170 umfassen. Wird beispielsweise weniger als ca. 75% des verfügbaren Platzes durch Bauelemente 155 verwendet, so kann die Rüstfamilie 175, 180 verworfen werden. Aufträge 210, die zusammen mit den zugeordneten Leiterplattentypen 122 bereits aus der Menge 205 entfernt worden sind, können beim Verwerfen wieder der Menge 205 zugeführt werden. Im Beispiel von Fig. 2 könnte die Rüstfamilie C eine solche unterbesetzte Rüstfamilie 175, 180 sein, die verworfen werden kann.

In einem nachfolgenden Schritt werden die Rüstfamilien 175, 180 in die Abfolge 250 gebracht. Dabei oder danach wird die Abfolge 250 bezüglich eines vorbestimmten Kriteriums optimiert. Das Kriterium kann beispielsweise umfassen, dass eine Anzahl von Rüstungen 175, 180 oder eine Anzahl von Rüstwechseln zwischen den Rüstungen 175, 180 minimiert wird. Eine Anzahl von Vorräten von Bauelementen 155, die in einer Rüstung 175, 180 an einem Rüsttisch 140 anzubringen ist, kann im Rahmen des Kriteriums zu maximieren sein. Ein Produktionsvolumen von Leiterplatten 120 mittels der Festrüstungs-Rüstfamilie 175 kann hingegen zu maximieren sein. Das Produktionsvolumen kann die Anzahl der bestückten Leiterplatten 120 betreffen. Es können auch mehrere Kennzahlen gewichtet oder ungewichtet zusammengefasst werden, um ein Kriterium zu bilden.

Die bestimmte Abfolge 250 von Rüstungen 175, 180 kann als ein Ergebnis des Verfahrens 200 bereitgestellt werden. Es können auch mehrere Abfolgen 250 bestimmt werden, die bezüglich des Kriteriums eine vorbestimmte Qualität erreichen. Eine Auswahl einer der Abfolgen 250 kann dann auf der Basis weiterer Parameter erfolgen.

Es ist bevorzugt, dass das Verfahren 200 mehrmals durchläuft, um die Abfolge 250 zu optimieren. Dabei werden bevorzugterweise einer oder mehrere Parameter über die verschiedenen Durchläufe des Verfahrens 200 variiert. Insbesondere kann die Zusammensetzung der Teilmenge 260 aus der Menge 205 variiert werden. Andere variierbare Parameter können beispielsweise eine Anzahl oder Zusammensetzung einer Festrüstung 165 mit zugeordneter Festrüstungs-Rüstfamilie 175, die Priorität 235 eines Auftrags 210, der einem Leiterplattentyp 122 zugeordnet ist, den oben beschriebenen Füllgrad einer Rüstung 175, 180 oder die Anzahl von Leiterplattentypen 122 in einer Rüstfamilie 175, 180 umfassen. Kombinationen mehrerer Parameter sind ebenfalls möglich. Außerdem kann zwischen einzelnen Durchläufen des Verfahrens 200 die Menge 205 in ihrer Zusammensetzung oder Mächtigkeit verändert worden sein.

Das Verfahren 200 läuft bevorzugterweise so lange, bis eine Abfolge 250 gefunden ist, deren Qualität bezüglich des beschriebenen Kriteriums einen vorbestimmen Schwellenwert erreicht, oder bis eine vorbestimmte Bestimmungsdauer des Verfahrens 200 abgelaufen ist. Konnte innerhalb der Bestimmungsdauer keine befriedigende Abfolge 250 gefunden werden, so können für eine erneute Bestimmung beispielsweise Nebenbedingungen zur Bildung der Rüstfamilien 175, 180 oder der Schwellenwert der geforderten Qualität angepasst werden.

Anschließend werden bevorzugterweise die Rüstungen 175, 180 der Abfolge 250 nacheinander an der Bestückungslinie 110 bereitgestellt und dazu verwendet, Leiterplatten 120 der korrespondierenden Rüstfamilien 175, 180 zu bestücken.

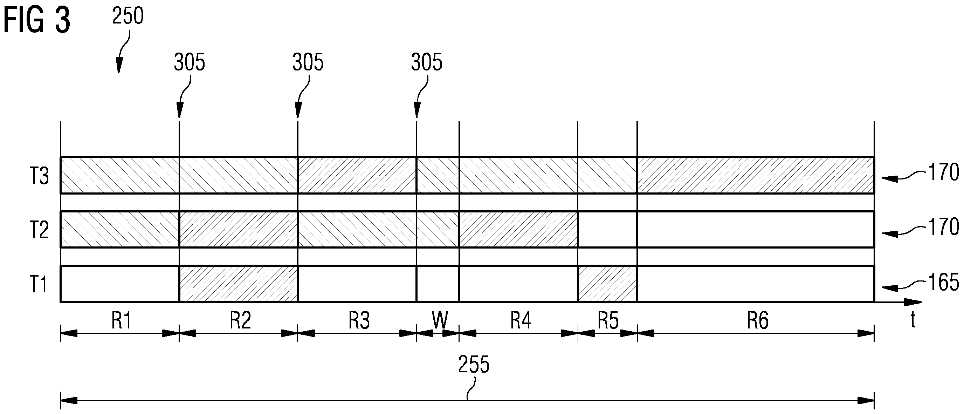

Figur 3 zeigt eine Abfolge 250 von Rüstungen 175, 180 an einer Bestückungslinie 110 des Bestückungssystems 100 von Figur 1. In horizontaler Richtung ist eine Zeit angetragen. Jede Rüstung 175, 180 ist im Beispiel von Figur 3 durch jeweils einen Rüsttisch 140 T1 bis T3 repräsentiert. Die Rüsttische T1 bis T3 sind in vertikaler Richtung angetragen und jeweils durch einen horizontalen Balken repräsentiert, der in einer hellen, abfallenden Schraffur gehalten ist, wenn der Rüsttisch T1 bis T3 in der Vorrüstung aufgerüstet wird, und in einer dunklen, aufsteigenden Schraffur, wenn der Rüsttisch T1 bis T3 an der Bestückungslinie 110 angebracht ist. Wird ein Rüsttisch T1 bis T3 nicht benutzt, ist im entsprechenden Balken keine Schraffur angebracht. Im Beispiel von Figur 3 trägt der Rüsttisch T1 eine Festrüstung 165 und die Rüsttische T2 und T3 tragen jeweils eine Variantenrüstung 170.

Zu Beginn des Planungshorizonts 255 wird zunächst eine erste Rüstung R1 an der Bestückungslinie 110 gerüstet, die von der Festrüstung 165 umfasst ist. Dementsprechend wird der Rüsttisch T1 an der Bestückungslinie 110 angebracht, während die Rüsttische T2 und T3 zur Bestückung mit Bauteilen zur Verfügung stehen. Ist die Produktionszeit der ersten Rüstung R1 beendet, so erfolgt ein Rüstwechsel 305 zu einer zweiten Rüstung R2. Die zweite Rüstung umfasst Bauelementetypen 160 der Variantenrüstung 170, die auf dem Wechseltisch T2 gerüstet sind. Während des Bestückens von Leiterplatten 120 mittels der zweiten Rüstung R2 kann der Rüsttisch T3 weiter vorgerüstet werden.

Nach einem weiteren Rüstwechsel 305 wird eine dritte Rüstung R3 an der Bestimmungslinie 110 bereitgestellt, die nur Bauelementetypen 160 umfasst, die auf dem Rüsttisch T3 gerüstet sind. Während mittels der Rüstung R3 bestückt wird, kann der Rüsttisch T2 umgerüstet werden.

Im vorliegenden Beispiel dauert jedoch das Umrüsten des Rüsttischs T2 länger als die Bestückung mittels der dritten Rüstung R3 dauert. Soll auf die Rüstung R3 eine Rüstung R4 folgen, die Bauelementetypen 160 erfordert, die auf dem Rüsttisch T2 gerüstet werden müssen, so kann eine Wartezeit W erforderlich sein, während derer keine Produktion mittels der Bestückungslinie 110 erfolgt.

Während des Bestückens mittels der Rüstung R4 kann der dritte Rüsttisch T3 umgerüstet werden. Erfordert das Umrüsten länger als die Produktionszeit mittels der Rüstung R4, so kann zur Vermeidung einer weiteren Wartezeit zwischen der Rüstung R4 und einer Rüstung R6, die Bauelementetypen 160 erfordert, die auf dem Rüsttisch T3 gerüstet sind, eine Rüstung R5 zwischengeschaltet werden, die von der Festrüstung 165 umfasst ist. Gegebenenfalls können von der Rüstung R5 auch Bauelementetypen 160 umfasst sein, die auf dem Rüsttisch T2 vorhanden sind.

Es wird klar, dass die Abfolge 250 von Rüstungen R1 bis R6 darüber entscheidet, ob und wann Wartezeiten W eingelegt werden müssen und wie viel Zeit diese in Anspruch nehmen. Dabei steht die Vermeidung von Wartezeiten W lediglich stellvertretend für eines von mehreren möglichen Kriterien zur Optimierung der Abfolge 250 von Rüstfamilien 175, 180 an der Bestückungslinie 110.

Obwohl die Erfindung im Detail durch das bevorzugte Ausführungsbeispiel näher illustriert und beschrieben wurde, ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren (200) zum Bestücken von Leiterplatten (120)
- mittels einer Bestückungslinie (110), die einen Bestückungsautomaten (130) mit einem Bestückkopf (135) umfasst,
- wobei mehrere Rüstungen (165, 170) mit jeweils zugeordneten Rüstfamilien (175, 180) vorgesehen sind;
- wobei jeder Rüstung (165, 170) eine Anzahl Bauelementetypen (160) und jeder Rüstfamilie (175, 180) eine Anzahl Leiterplattentypen (122) zugeordnet ist,
- sodass eine Leiterplatte (120) eines Leiterplattentyps (122) einer Rüstfamilie (175, 180) mittels Bauelementen (155) der Bauelementetypen (160) der Rüstung (165, 170) an der Bestücklinie (110) bestückt werden kann;
- wobei ein Rüsttisch (140) mit einem Vorrat von Bauelementen (155) eines Bauelementetyps (160) einer Rüstung (165, 170) an der Bestückungslinie (110) bereitgestellt werden kann;
- wobei der Bestückkopf (135) dazu eingerichtet ist, ein Bauelement (155) von einem Rüsttisch (140) aufzunehmen;
wobei das Verfahren folgende Schritte umfasst:
- Erfassen von Leiterplattentypen (122), von denen Leiterplatten (120) mit Bauelementen (155) zugeordneter Bauelementetypen (160) bestückt werden sollen;
- Zuordnen von erfassten Leiterplattentypen (122) zu Rüstfamilien (175, 180),
- Bestimmen einer Abfolge (250), in der die Rüstungen (165, 170) der gebildeten Rüstfamilien (175, 180) an der Bestückungslinie (110) gerüstet werden sollen;
- Optimieren der Abfolge (250) bezüglich eines vorbestimmten Kriteriums;
- wobei in der Abfolge (250) auf eine erste Rüstung (165, 170) eine zweite Rüstung (165, 170) folgt und das Kriterium umfasst, dass eine Wartezeit zwischen dem Ende der Bestückung von Leiterplatten (120) mittels der ersten Rüstung (165, 170) und dem fertigen Bereitstellen eines Rüsttischs (140) mit einem Vorrat von Bauelementen (155) eines Bauelementetyps (160) der zweiten Rüstung (165, 170) möglichst klein ist; und
- Bestücken von Leiterplatten (120) mittels Rüstungen (165, 170) in der vorbestimmten Abfolge,
**dadurch gekennzeichnet, dass**
- das Optimieren ein wiederholtes Zuordnen von Leiterplattentypen (122) zu Rüstfamilien (175, 180) mit wenigstens einem geänderten Parameter, um das Kriterium zu optimieren, umfasst, sodass das Zuordnen, das Bestimmen der Abfolge und das Optimieren der Abfolge unter Variation des Parameters durchgeführt wird;
- wobei die Menge der erfassten Leiterplattentypen (122) größer als die Menge der zugeordneten Leiterplattentypen (122) ist;
- wobei der Parameter eine Auswahl von zugeordneten Leiterplattentypen (122) aus der Menge (205) der erfassen Leiterplattentypen (122) umfasst.

2. Verfahren (200) nach Anspruch 1, wobei das Kriterium eines von einer Anzahl von Rüstungen (165, 170), einer Anzahl Rüstwechsel (305), einer Anzahl von an Rüsttischen (140) anzubringenden Vorräten von Bauelementen (155) und einem Produktionsvolumen in einer Festrüstung (165) umfasst.

3. Verfahren (200) nach einem der vorangehenden Ansprüche, wobei eine der bestimmten Rüstungen eine Festrüstung (165) ist, deren Bauelementetypen (160) unverändert an einem oder mehreren Rüsttischen (140) gerüstet bleiben, so lange Leiterplatten (120) mittels Rüstungen der bestimmten Abfolge (250) bestückt werden.

4. Verfahren (200) nach einem der vorangehenden Ansprüche, wobei der Parameter die Menge der erfassten Leiterplattentypen (122) umfasst.

5. Verfahren (200) nach einem der vorangehenden Ansprüche, wobei der Parameter wenigstens eine von folgenden Größen umfasst:
- eine Festrüstung (165), die Rüsttische (140) umfasst, deren zugeordnete Bauelementetypen (160) nicht verändert werden;
- eine Priorität (235), die einem Auftrag (210) zur Bestückung von Leiterplatten (120) zugeordnet ist;
- einen Füllgrad einer Rüstung (165, 170);
- eine Anzahl von Leiterplattentypen (122) in einer Rüstfamilie (175, 180).

6. Verfahren (200) nach Anspruch 5, wobei eine gewichtete Kombination mehrerer Kriterien verwendet wird.

## Claims

1. Method (200) for the population of printed circuit boards (120)
- using a pick-and-place line (110) comprising an automatic pick-and-place unit (130) having a pick-and-place head (135),
- wherein multiple set-ups (165, 170), each having associated set-up families (175, 180), are provided;
- wherein a number of component types (160) is associated with each set-up (165, 170) and a number of printed circuit board types (122) is associated with each set-up family (175, 180),
- such that a printed circuit board (120) of a printed circuit board type (122) in a set-up family (175, 180) can be populated on the pick-and-place line (110) using components (155) of the component types (160) in the set-up (165, 170);
- wherein a set-up table (140) comprising a stock of components (155) of a component type (160) in a set-up (165, 170) can be provided on the pick-and-place line (110);
- wherein the pick-and-place head (135) is configured to pick up a component (155) from a set-up table (140);
wherein the method comprises the following steps:
- recording of printed circuit board types (122), of which printed circuit boards (120) are to be populated with components (155) of associated component types (160);
- association of recorded printed circuit board types (122) with set-up families (175, 180),
- determination of a sequence (250) in which the set-ups (165, 170) of the set-up families (175, 180) that have been formed are to be fitted on the pick-and-place line (110);
- optimization of the sequence (250) with respect to a predetermined criterion;
- wherein, in the sequence (250), a first set-up (165, 170) is followed by a second set-up (165, 170), and the criterion comprises that a waiting time between the end of the population of printed circuit boards (120) using the first set-up (165, 170) and the completed delivery of a set-up table (140) with a stock of components (155) of a component type (160) for the second set-up (165, 170) is as short as possible; and
- population of printed circuit boards (120) in the predetermined sequence, using set-ups (165, 170), **characterized in that**
- the optimization comprises repeated association of printed circuit board types (122) with set-up families (175, 180) with at least one modified parameter, in order to optimize the criterion, such that the association, the determination of the sequence and the optimization of the sequence are carried out with variation of the parameter;
- wherein the quantity of the recorded printed circuit board types (122) is greater than the quantity of the associated printed circuit board types (122);
- wherein the parameter comprises a selection of associated printed circuit board types (122) from the quantity (205) of the recorded printed circuit board types (122).

2. Method (200) according to Claim 1, wherein the criterion comprises one of the following: a number of set-ups (165, 170), a number of set-up changeovers (305), a number of stocks of components (155) to be installed on set-up tables (140), and a production volume in a fixed set-up (165).

3. Method (200) according to any of the preceding claims, wherein one of the determined set-ups is a fixed set-up (165), of which the component types (160) remain fitted in an unchanged manner on one or more set-up tables (140) for as long as printed circuit boards (120) are populated using set-ups in the determined sequence (250).

4. Method (200) according to any of the preceding claims, wherein the parameter comprises the quantity of printed circuit board types (122) recorded.

5. Method (200) according to any of the preceding claims, wherein the parameter comprises at least one of the following variables:
- a fixed set-up (165) comprising set-up tables (140), the associated component types (160) of which are not changed;
- a priority (235), which is assigned to an order (210) for the population of printed circuit boards (120);
- a set-up (165, 170) fullness factor;
- a number of printed circuit board types (122) in a set-up family (175, 180).

6. Method (200) as claimed in Claim 5, wherein a weighted combination of multiple criteria is employed.

## Revendications

1. Procédé (200) pour équiper des cartes de circuits imprimés (120)
- au moyen d'une chaîne à équiper (110) qui comprend un appareil à équiper automatique (130) avec une tête d'équipement (135),
- plusieurs équipements (165, 170) étant prévus avec des familles d'équipements (175, 180) respectivement affectées ;
- un certain nombre de types de composants (160) étant affectés à chaque équipement (165, 170), et un certain nombre de types de cartes de circuits imprimés (122) étant affectés à chaque famille d'équipements (175, 180),
- de sorte qu'une carte de circuits imprimés (120) d'un type de cartes de circuits imprimés (122) d'une famille d'équipements (175, 180) peut être équipée sur la chaîne à équiper (110) au moyen de composants (155) des types de composants (160) de l'équipement (165, 170) ;
- une table d'équipement (140) pouvant être fournie sur la chaîne à équiper (110), avec un stock de composants (155) d'un type de composants (160) d'un équipement (165, 170) ;
- la tête d'équipement (135) étant aménagée pour ramasser un composant (155) à partir d'une table d'équipement (140) ;
le procédé comprenant les étapes suivantes :
- détection de types de cartes de circuits imprimés (122) dont des cartes de circuits imprimés (120) doivent être équipées avec des composants (155) de types de composants (160) affectés ;
- affectation de types de cartes de circuits imprimés (122) détectés à des familles d'équipements (175, 180),
- détermination d'un ordre de succession (250) dans lequel les équipements (165, 170) des familles d'équipements (175, 180) formées doivent être montés sur la chaîne à équiper (110) ;
- optimisation de l'ordre de succession (250) en ce qui concerne un critère prédéterminé ;
- un deuxième équipement (165, 170) succédant à un premier équipement (165, 170) dans l'ordre de succession (250) et comprenant le critère tel qu'un temps d'attente entre la fin de l'équipement de cartes de circuits imprimés (120) au moyen du premier équipement (165, 170) et la fourniture finale d'une table d'équipement (140) avec un stock de composants (155) d'un type de composants (160) du deuxième équipement (165, 170) est le plus court possible ; et
- équipement de cartes de circuits imprimés (120) au moyen d'équipements (165, 170) dans l'ordre de succession prédéfini, **caractérisé en ce que**
- l'optimisation comprend une affectation répétée de types de cartes de circuits imprimés (122) à des familles d'équipements (175, 180) avec au moins un paramètre modifié pour optimiser un critère de sorte que l'affectation, la détermination de l'ordre de succession et l'optimisation de l'ordre de succession sont effectuées en étant accompagnées d'une variation du paramètre ;
- la quantité de types de cartes de circuits imprimés (122) détectés est supérieure à la quantité des types de cartes de circuits imprimés (122) affectés;
- le paramètre comprenant une sélection de types de cartes de circuits imprimés (122) affectées parmi la quantité (205) des types de cartes de circuits imprimés (122) détectés.

2. Procédé (200) selon la revendication 1, le critère comprenant un critère parmi un nombre d'équipements (165, 170), un nombre de changement d'équipement (305), un nombre de stocks de composants (155) à mettre en place sur des tables d'équipement (140) et un volume de production dans un équipement fixe (165).

3. Procédé (200) selon l'une des revendications précédentes, un des équipements déterminés étant un équipement fixe (165) dont les types de composants (160) demeurent montés de façon inchangée sur une ou plusieurs tables d'équipement (140) tant que des cartes de circuits imprimés (120) sont équipées au moyen d'équipements de l'ordre de succession (250) déterminé.

4. Procédé (200) selon l'une des revendications précédentes, le paramètre comprenant la quantité des types de cartes de circuits imprimés (122) détectés.

5. Procédé (200) selon l'une des revendications précédentes, le paramètre comprenant au moins une des grandeurs suivantes :
- un équipement fixe (165) qui comprend des tables d'équipement (140) dont les types de composants (160) affectés ne sont pas modifiés ;
- une priorité (235) qui est affectée à une commande (210) d'équipement de cartes de circuits imprimés (120) ;
- un degré de remplissage d'un équipement (165, 170) ;
- un nombre de types de cartes de circuits imprimés (122) dans une famille d'équipements (175, 180).

6. Procédé (200) selon la revendication 5, une combinaison pondérée de plusieurs critères étant utilisée.
